# EUROPEAN PATENT APPLICATION

(11) **EP 4 513 551 A1**
(43) Date of publication of application: **26.02.2025**
(21) Application number: 24805094.0
(22) Date of filing: 08.05.2024
(51) Int. Cl.: H01L 23/48, G11C 11/401, H10B 12/00, H10B 80/00

(54) **MEMORY CHIP, CHIP STACK STRUCTURE AND MEMORY**

(30) Priority: 08.06.2023 CN 202310680606
(71) Applicant: CXMT Corporation, Hefei, Anhui 230601 (CN)
(72) Inventor: ZHANG, Jiarui, Hefei, Anhui 230601 (CN); MARUNO, Seiichi, Hefei, Anhui 230601 (CN)
(74) Representative: Gulde & Partner
(86) International application number: PCT/CN2024/091605
(87) International publication number: WO 2024/250893

(57) **Abstract**

The present disclosure provides a memory chip, a chip stacked structure, and a memory. For the memory chip, n via groups in a first region are symmetrical to n via groups in a second region with respect to a first axis, n via groups in a third region are symmetrical to n via groups in a fourth region with respect to the first axis, and the n via groups in the first region are symmetrical to the n via groups in the fourth region with respect to a second axis. For each via group, a first via is symmetrical to a second via with respect to a third axis, a third via is symmetrical to a fourth via with respect to the third axis, and the first via is symmetrical to the fourth via with respect to a fourth axis.

## Description

### CROSS-REFERENCE TO RELATED APPLICATIONS

This application claims priority to Chinese Patent Application No. 202310680606.3, filed with the China National Intellectual Property Administration on June 8, 2023 and entitled "MEMORY CHIP, CHIP STACKED STRUCTURE, AND MEMORY", which is incorporated herein by reference in its entirety.

### TECHNICAL FIELD

The present disclosure relates to but is not limited to a memory chip, a chip stacked structure, and a memory.

### BACKGROUND

With the development of integrated circuit technologies, significant progress has been made in manufacturing processes of semiconductor devices. However, in recent years, various challenges such as a physical limit, an existing developing technology limit, and a storage electron density limit have been posed to the development of two-dimensional semiconductor technologies. In this context, to address the difficulties encountered by two-dimensional semiconductor devices and pursue lower manufacturing costs per memory cell, a bonding process may be employed to stack multiple chips to form a three-dimensional semiconductor device. However, for the three-dimensional semiconductor device, a connection structure between different chips is still confronted with problems such as high parasitic capacitance and high parasitic resistance, affecting signal transmission quality.

### SUMMARY

The present disclosure provides a memory chip, a chip stacked structure, and a memory.

The technical solutions of the present disclosure are implemented as follows.

According to a first aspect, an embodiment of the **present** disclosure provides a memory chip. The memory chip includes 2×2 regions distributed in an array along an active surface of the memory chip. n via groups run through each of the regions, and n is a natural number. n via groups in a first region are symmetrical to n via groups in a second region with respect to a first axis, n via groups in a third region are symmetrical to n via groups in a fourth region with respect to the first axis, and the n via groups in the first region are symmetrical to the n via groups in the fourth region with respect to a second axis. Both the first axis and the second axis are located on the active surface, and the first axis and the second axis are perpendicular to each other and intersect at a center of the active surface. For each of the via groups, the via group includes 2×2 vias distributed in an array, a first via is symmetrical to a second via with respect to a third axis, a third via is symmetrical to a fourth via with respect to the third axis, and the first via is symmetrical to the fourth via with respect to a fourth axis. Both the third axis and the fourth axis are located on the active surface, and the third axis and the fourth axis are perpendicular to each other and intersect at a center of the via group. The first axis and third axes of the via groups are parallel to a first side edge of the memory chip, and the second axis and fourth axes of the via groups are parallel to a second side edge of the memory chip.

In some embodiments, n first vias in the first region are symmetrical to n second vias in the second region with respect to the first axis; n third vias in the third region are symmetrical to n fourth vias in the fourth region with respect to the first axis; and the n first vias in the first region are symmetrical to the n fourth vias in the fourth region with respect to the second axis.

In some embodiments, n second vias in the first region are symmetrical to n first vias in the second region with respect to the first axis; n fourth vias in the third region are symmetrical to n third vias in the fourth region with respect to the first axis; and the n second vias in the first region are symmetrical to the n third vias in the fourth region with respect to the second axis.

In some embodiments, n third vias in the first region are symmetrical to n fourth vias in the second region with respect to the first axis; n first vias in the third region are symmetrical to n second vias in the fourth region with respect to the first axis; and the n third vias in the first region are symmetrical to the n second vias in the fourth region with respect to the first axis.

In some embodiments, n fourth vias in the first region are symmetrical to n third vias in the second region with respect to the first axis; n second vias in the third region are symmetrical to n first vias in the fourth region with respect to the first axis; and the n fourth vias in the first region are symmetrical to the n first vias in the fourth region with respect to the second axis.

In some embodiments, any one of the vias runs through the memory chip in a direction perpendicular to the active surface, and different vias in the same memory chip are electrically isolated from each other.

In some embodiments, the memory chip further includes 4n first drive circuits. 4n vias are connected to the 4n first drive circuits in one-to-one correspondence, and only one via in each via group is connected to one of the first drive circuits.

In some embodiments, the memory chip further includes a positioning structure. The positioning structure is located in a reference region to identify a location of the reference region. The reference region is one of the 2×2 regions.

According to a second aspect, an embodiment of the present disclosure provides a chip stacked structure. The chip stacked structure includes at least one stacked unit, each stacked unit includes a first memory chip, a second memory chip, a third memory chip, and a fourth memory chip sequentially stacked in a third direction, the third direction is perpendicular to an active surface of each of the memory chips, and each of the first memory chip, the second memory chip, the third memory chip, and the fourth memory chip is the memory chip according to the first aspect. The first memory chip and the second memory chip are stacked in a face-to-face manner, the second memory chip and the third memory chip are stacked in a back-to-back manner, and the third memory chip and the fourth memory chip are stacked in a face-to-face manner.

In some embodiments, a first region in the first memory chip, a second region in the second memory chip, a third region in the third memory chip, and a fourth region in the fourth memory chip are aligned with each other in the third direction; a second region in the first memory chip, a first region in the second memory chip, a fourth region in the third memory chip, and a third region in the fourth memory chip are aligned with each other in the third direction; a third region in the first memory chip, a fourth region in the second memory chip, a first region in the third memory chip, and a second region in the fourth memory chip are aligned with each other in the third direction; and a fourth region in the first memory chip, a third region in the second memory chip, a second region in the third memory chip, and a first region in the fourth memory chip are aligned with each other in the third direction.

In some embodiments, n first vias in the first region in the first memory chip, n second vias in the second region in the second memory chip, n third vias in the third region in the third memory chip, and n fourth vias in the fourth region in the fourth memory chip are aligned with each other in the third direction; n second vias in the first region in the first memory chip, n first vias in the second region in the second memory chip, n fourth vias in the third region in the third memory chip, and n third vias in the fourth region in the fourth memory chip are aligned with each other in the third direction; n third vias in the first region in the first memory chip, n fourth vias in the second region in the second memory chip, n first vias in the third region in the third memory chip, and n second vias in the fourth region in the fourth memory chip are aligned with each other in the third direction; and n fourth vias in the first region in the first memory chip, n third vias in the second region in the second memory chip, n second vias in the third region in the third memory chip, and n first vias in the fourth region in the fourth memory chip are aligned with each other in the third direction.

In some embodiments, n first vias in the second region in the first memory chip, n second vias in the first region in the second memory chip, n third vias in the fourth region in the third memory chip, and n fourth vias in the third region in the fourth memory chip are aligned with each other in the third direction; n second vias in the second region in the first memory chip, n first vias in the first region in the second memory chip, n fourth vias in the fourth region in the third memory chip, and n third vias in the third region in the fourth memory chip are aligned with each other in the third direction; n third vias in the second region in the first memory chip, n fourth vias in the first region in the second memory chip, n first vias in the fourth region in the third memory chip, and n second vias in the third region in the fourth memory chip are aligned with each other in the third direction; and n fourth vias in the second region in the first memory chip, n third vias in the first region in the second memory chip, n second vias in the fourth region in the third memory chip, and n first vias in the third region in the fourth memory chip are aligned with each other in the third direction.

In some embodiments, n first vias in the third region in the first memory chip, n second vias in the fourth region in the second memory chip, n third vias in the first region in the third memory chip, and n fourth vias in the second region in the fourth memory chip are aligned with each other in the third direction; n second vias in the third region in the first memory chip, n first vias in the fourth region in the second memory chip, n fourth vias in the first region in the third memory chip, and n third vias in the second region in the fourth memory chip are aligned with each other in the third direction; n third vias in the third region in the first memory chip, n fourth vias in the fourth region in the second memory chip, n first vias in the first region in the third memory chip, and n second vias in the second region in the fourth memory chip are aligned with each other in the third direction; and n fourth vias in the third region in the first memory chip, n third vias in the fourth region in the second memory chip, n second vias in the first region in the third memory chip, and n first vias in the second region in the fourth memory chip are aligned with each other in the third direction.

In some embodiments, n first vias in the fourth region in the first memory chip, n second vias in the third region in the second memory chip, n third vias in the second region in the third memory chip, and n fourth vias in the first region in the fourth memory chip are aligned with each other in the third direction; n second vias in the fourth region in the first memory chip, n first vias in the third region in the second memory chip, n fourth vias in the second region in the third memory chip, and n third vias in the first region in the fourth memory chip are aligned with each other in the third direction; n third vias in the fourth region in the first memory chip, n fourth vias in the third region in the second memory chip, n first vias in the second region in the third memory chip, and n second vias in the first region in the fourth memory chip are aligned with each other in the third direction; and n fourth vias in the fourth region in the first memory chip, n third vias in the third region in the second memory chip, n second vias in the second region in the third memory chip, and n first vias in the first region in the fourth memory chip are aligned with each other in the third direction.

In some embodiments, a first region in the first memory chip, a fourth region in the second memory chip, a third region in the third memory chip, and a second region in the fourth memory chip are aligned with each other in the third direction; a second region in the first memory chip, a third region in the second memory chip, a fourth region in the third memory chip, and a first region in the fourth memory chip are aligned with each other in the third direction; a third region in the first memory chip, a second region in the second memory chip, a first region in the third memory chip, and a fourth region in the fourth memory chip are aligned with each other in the third direction; and a fourth region in the first memory chip, a first region in the second memory chip, a second region in the third memory chip, and a third region in the fourth memory chip are aligned with each other in the third direction.

In some embodiments, n first vias in the first region in the first memory chip, n fourth vias in the fourth region in the second memory chip, n third vias in the third region in the third memory chip, and n second vias in the second region in the fourth memory chip are aligned with each other in the third direction; n second vias in the first region in the first memory chip, n third vias in the fourth region in the second memory chip, n fourth vias in the third region in the third memory chip, and n first vias in the second region in the fourth memory chip are aligned with each other in the third direction; n third vias in the first region in the first memory chip, n second vias in the fourth region in the second memory chip, n first vias in the third region in the third memory chip, and n fourth vias in the second region in the fourth memory chip are aligned with each other in the third direction; and n fourth vias in the first region in the first memory chip, n first vias in the fourth region in the second memory chip, n second vias in the third region in the third memory chip, and n third vias in the second region in the fourth memory chip are aligned with each other in the third direction.

In some embodiments, n first vias in the second region in the first memory chip, n fourth vias in the third region in the second memory chip, n third vias in the fourth region in the third memory chip, and n second vias in the first region in the fourth memory chip are aligned with each other in the third direction; n second vias in the second region in the first memory chip, n third vias in the third region in the second memory chip, n fourth vias in the fourth region in the third memory chip, and n first vias in the first region in the fourth memory chip are aligned with each other in the third direction; n third vias in the second region in the first memory chip, n second vias in the third region in the second memory chip, n first vias in the fourth region in the third memory chip, and n fourth vias in the first region in the fourth memory chip are aligned with each other in the third direction; and n fourth vias in the second region in the first memory chip, n first vias in the third region in the second memory chip, n second vias in the fourth region in the third memory chip, and n third vias in the first region in the fourth memory chip are aligned with each other in the third direction.

In some embodiments, n first vias in the third region in the first memory chip, n fourth vias in the second region in the second memory chip, n third vias in the first region in the third memory chip, and n second vias in the fourth region in the fourth memory chip are aligned with each other in the third direction; n second vias in the third region in the first memory chip, n third vias in the second region in the second memory chip, n fourth vias in the first region in the third memory chip, and n first vias in the fourth region in the fourth memory chip are aligned with each other in the third direction; n third vias in the third region in the first memory chip, n second vias in the second region in the second memory chip, n first vias in the first region in the third memory chip, and n fourth vias in the fourth region in the fourth memory chip are aligned with each other in the third direction; and n fourth vias in the third region in the first memory chip, n first vias in the second region in the second memory chip, n second vias in the first region in the third memory chip, and n third vias in the fourth region in the fourth memory chip are aligned with each other in the third direction.

In some embodiments, n first vias in the fourth region in the first memory chip, n fourth vias in the first region in the second memory chip, n third vias in the second region in the third memory chip, and n second vias in the third region in the fourth memory chip are aligned with each other in the third direction; n second vias in the fourth region in the first memory chip, n third vias in the first region in the second memory chip, n fourth vias in the second region in the third memory chip, and n first vias in the third region in the fourth memory chip are aligned with each other in the third direction; n third vias in the fourth region in the first memory chip, n second vias in the first region in the second memory chip, n first vias in the second region in the third memory chip, and n fourth vias in the third region in the fourth memory chip are aligned with each other in the third direction; and n fourth vias in the fourth region in the first memory chip, n first vias in the first region in the second memory chip, n second vias in the second region in the third memory chip, and n third vias in the third region in the fourth memory chip are aligned with each other in the third direction.

In some embodiments, in two memory chips connected face-to-face, vias aligned with each other in the third direction are connected through hybrid bonding structures; and in two memory chips connected back-to-back, vias aligned with each other in the third direction are connected through conductive bumps; or in two memory chips connected face-to-face or two memory chips connected back-to-back, vias aligned with each other in the third direction are connected through hybrid bonding structures; or in two memory chips connected face-to-face or two memory chips connected back-to-back, vias aligned with each other in the third direction are connected through conductive bumps.

In some embodiments, each of the memory chips further includes 4n first drive circuits. In each of the memory chips, 4n first drive circuits are connected to first terminals of 4n first vias in one-to-one correspondence. The first terminals are located on an active surface of the memory chip.

In some embodiments, the chip stacked structure further includes a logic chip. The first stacked unit is stacked on the logic chip in the third direction, and each of the remaining stacked units is stacked on a previous stacked unit in the third direction. The logic chip includes 16n fifth vias and 16n second drive circuits, 4n fifth vias are aligned with the 4n first vias in the first memory chip in the third direction in one-to-one correspondence, 4n fifth vias are aligned with the 4n second vias in the first memory chip in the third direction in one-to-one correspondence, 4n fifth vias are aligned with the 4n third vias in the first memory chip in the third direction in one-to-one correspondence, and 4n fifth vias are aligned with the 4n fourth vias in the first memory chip in the third direction in one-to-one correspondence. The 16n second drive circuits are connected to first terminals of the 16n fifth vias in one-to-one correspondence, and the first terminals are located on an active surface of the logic chip.

In some embodiments, the chip stacked structure further includes 16n electrical paths. One fifth via, m first vias, m second vias, m third vias, and m fourth vias aligned with each other in the third direction are connected to form one electrical path if the chip stacked structure includes m stacked units, and m is a positive integer.

According to a third aspect, an embodiment of the present disclosure provides a memory. The memory includes the chip stacked structure according to the second aspect.

Embodiments of the present disclosure provide a memory chip, a chip stacked structure, and a memory, to reduce the quantity of disposed drive circuits and data selectors, so that parasitic capacitance is reduced. In addition, a chip stacked structure formed by memory chips implements a rotational transmission effect of a signal with a direct connection configuration of vias, and further reduces parasitic resistance.

### BRIEF DESCRIPTION OF DRAWINGS

FIG. 1 is a schematic diagram of signal transmission in a chip stacked structure;
FIG. 2 is a schematic diagram of signal transmission in another chip stacked structure;
FIG. 3 is a schematic structural diagram of a memory chip according to an embodiment of the present disclosure;
FIG. 4 is a schematic structural diagram of another memory chip according to an embodiment of the present disclosure;
FIG. 5 is a schematic structural diagram of still another memory chip according to an embodiment of the present disclosure;
FIG. 6 is a schematic structural diagram of a chip stacked structure according to an embodiment of the present disclosure;
FIG. 7 is a schematic diagram 1 of a first-type chip stacked structure according to an embodiment of the present disclosure;
FIG. 8 is a schematic diagram 2 of a first-type chip stacked structure according to an embodiment of the present disclosure;
FIG. 9 is a schematic diagram 3 of a first-type chip stacked structure according to an embodiment of the present disclosure;
FIG. 10 is a schematic diagram 1 of a second-type chip stacked structure according to an embodiment of the present disclosure;
FIG. 11 is a schematic diagram 2 of a second-type chip stacked structure according to an embodiment of the present disclosure;
FIG. 12 is a schematic diagram 3 of a second-type chip stacked structure according to an embodiment of the present disclosure;
FIG. 13 is a schematic diagram of signal transmission of a first-type chip stacked structure according to an embodiment of the present disclosure;
FIG. 14 is a schematic diagram of signal transmission of a second-type chip stacked structure according to an embodiment of the present disclosure; and
FIG. 15 is a schematic structural diagram of a memory according to an embodiment of the present disclosure.

### DESCRIPTION OF EMBODIMENTS

The technical solutions in the embodiments of the present disclosure are clearly described below with reference to the accompanying drawings in the embodiments of the present disclosure. It may be understood that specific embodiments described herein are merely intended to explain the related application, but are not intended to limit this application. In addition, it should be further noted that for ease of description, only a part related to the related application is shown in the accompanying drawings. Unless otherwise defined, all technical and scientific terms adopted in this specification have meanings the same as those commonly understood by a person skilled in the technical field of the present disclosure. The terms adopted in this specification are merely intended to describe the embodiments of the present disclosure, but are not intended to limit the present disclosure. The following descriptions relate to "some embodiments" describing a subset of all possible embodiments. However, it may be understood that "some embodiments" may be the same subset or different subsets of all the possible embodiments, and may be combined with each other when there is no conflict. It should be noted that the term "first/second/third" in the embodiments of the present disclosure is merely intended to distinguish between similar objects, and does not represent specific sorting for the objects. It may be understood that "first/second/third" may be interchanged for a specific sequence or order if allowed, so that the embodiments of the present disclosure described herein can be implemented in a sequence other than those shown or described.
Dynamic random access memory (DRAM);
synchronous dynamic random access memory (SDRAM);
double data rate SDRAM (DDR); and
low power DDR (LPDDR).

Before the embodiments of the present disclosure are described, three directions that may be configured to describe a three-dimensional structure of a plane in the following embodiments are first defined. In an example of a Cartesian coordinate system, the three directions may include an X-axis direction, a Y-axis direction, and a Z-axis direction (not involved in the embodiments of the present disclosure). A semiconductor chip may include a top surface (active surface) located on the front and a bottom surface (inactive surface) located on the back opposite to the front. When flatness of the top surface and the bottom surface is ignored, a direction intersecting with (e.g., perpendicular to) the top surface and the bottom surface of the semiconductor chip is defined as a third direction. Two directions, namely, a first direction and a second direction, intersecting with each other are defined on the active surface of the semiconductor chip. An active-surface direction of the semiconductor chip may be determined based on the first direction and the second direction. In the embodiments of the present disclosure, the first direction and the second direction may be perpendicular to each other. In another embodiment, the first direction and the second direction may not be perpendicular to each other.

In particular, the illustrations presented in the present disclosure are not meant to be actual views of any specific microelectronic apparatus or components thereof, but are only idealized representations for describing illustrative embodiments. Therefore, the illustrations are not necessarily drawn to scale.

The embodiments of the present disclosure are described below in detail with reference to the accompanying drawings.

In an embodiment, a memory chip is provided. The memory chip includes multiple vias (also referred to as through silicon vias and configured to implement signal transmission between different chips) running through the memory chip, and all the vias may be located at any location. In particular, every four vias may be considered as one via group in terms of function, but respective locations of the four vias are not limited.

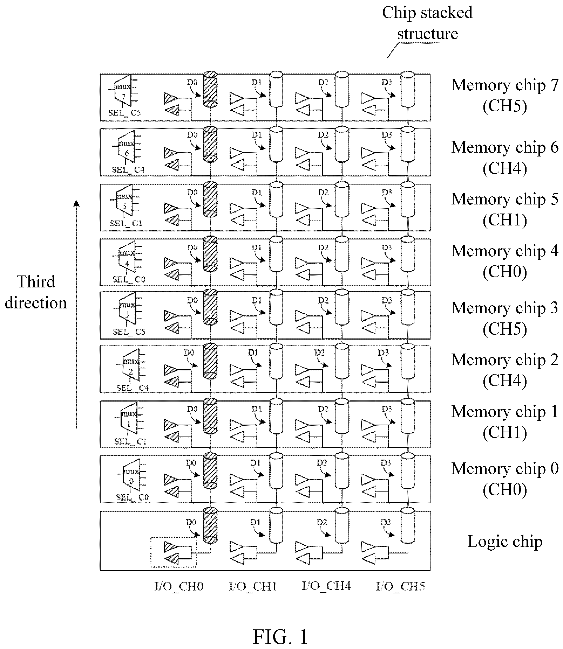

In a specific embodiment, eight memory chips and one logic chip are stacked to form a 3D memory device, respective vias of the eight memory chips are aligned with each other in the third direction, and nine vias aligned with each other in the third direction are connected to form one electrical path. FIG. 1 is a schematic diagram of signal transmission in a chip stacked structure. As shown in FIG. 1, the chip stacked structure includes memory chips 0 to 7 and a logic chip. In FIG. 1, only four vias D0 to D3 are shown for each memory chip, and the four vias D0 to D3 belong to the same via group. In this case, vias D0 in the eight memory chips and one logic chip are all aligned with each other to form one electrical path, vias D1 in the eight memory chips and one logic chip are all aligned with each other to form one electrical path, and there is a similar case for the remaining vias.

In addition, multiple drive circuits are further disposed in each memory chip and the logic chip (in FIG. 1, only one drive circuit is shown in a dotted-line box, and the remaining drive circuits are not shown in a box), and each via is connected to one drive circuit. Multiple data selectors (e.g., mux0 to mux7 in FIG. 1) are further disposed in each memory chip, and each via group corresponds to one data selector, to be specific, all vias in one via group are connected to a data port of the data selector through respective drive circuits. In other words, the data selector may choose to output, to the inside of the memory chip, a signal transmitted by a specific via or output, to a specific via, a signal output by the memory chip.

For an overall memory device, the eight memory chips are classified into four channels (CH0, CH1, CH4, and CH5) for management. A memory chip 0 and a memory chip 4 belong to the channel CH0, a memory chip 1 and a memory chip 5 belong to the channel CH1, a memory chip 2 and a memory chip 6 belong to the channel CH4, and a memory chip 3 and a memory chip 7 belong to the channel CH5. Correspondingly, an input/output signal I/O_CH0 on the channel CH0 is transmitted through an electrical path including "the via D0 in the logic chip and the via D0 in the memory chip 0 -- the via D0 in the memory chip 1 -- the via D0 in the memory chip 2-- the via D0 in the memory chip 3 -- the via D0 in the memory chip 4 -- the via D0 in the memory chip 5 -- the via D0 in the memory chip 6 -- the via D0 in the memory chip 7". Selection signals of a data selector mux0 in the memory chip 0 and a data selector mux4 in the memory chip 4 are both SEL _C0, in other words, the input/output signal I/O_CH0 may enter the memory chip 0 and the memory chip 4 through the foregoing electrical path. A signal output procedure may be similarly understood.

It can be learned from the foregoing descriptions that the memory chip 0 needs to obtain a signal only from the via D0, the memory chip 1 needs to obtain a signal only from the via D1, and so on. In other words, each memory chip needs to obtain a signal only from one via in a via group. It should be noted that different memory chips may need to obtain signals from different vias. However, during process manufacturing, all the memory chips need to be designed into the exactly same structure (to maximize cost and labor savings). Therefore, all vias in the memory chips need to be designed with corresponding drive structures and data selectors, to implement structural consistency. Further, when the chip stacked structure shown in FIG. 1 is employed, each via corresponds to one drive circuit; and all drive circuits in all memory chips on the same channel need to be driven in a working procedure of the chip stacked structure, resulting in relatively heavy load and relatively high parasitic capacitance. This seriously affects performance of the chips in the chip stacked structure, restricts transmission efficiency, increases power consumption, and restricts the quantity of stacked chips in a three-dimensional device.

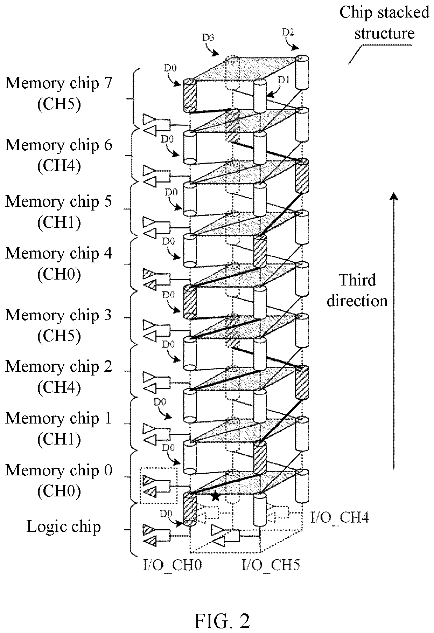

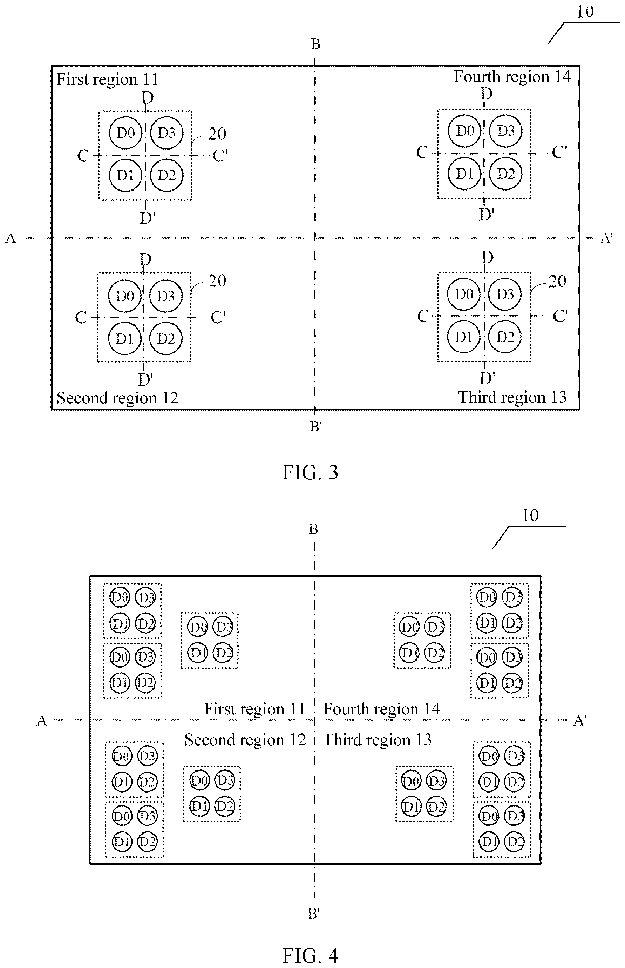

In another embodiment, FIG. 2 is a schematic diagram of signal transmission in another chip stacked structure. In particular, in FIG. 2, only some vias (D0 to D3) are identified, and other vias are omitted. However, for FIG. 4, identifiers of vias aligned with each other in a third direction are the same. As shown in FIG. 2, the chip stacked structure also includes eight memory chips and one logic chip that are aligned with each other in the third direction. However, each of vias in each memory chip is rotatably connected to another via at a different location in another memory chip, to implement a spiral upward connection on the whole. To be specific, an input/output signal I/O_CH0 on a channel CH0 is transmitted through "a via D0 in the logic chip -- a via D1 in a memory chip 0 -- a via D2 in a memory chip 1 -- a via D3 in a memory chip 2 -- a via D0 in a memory chip 3 -- a via D1 in a memory chip 4 -- a via D2 in a memory chip 5 -- a via D3 in a memory chip 6 -- a via D0 in a memory chip 7", and there is a similar case for the remaining signals.

In this way, the memory chip 0 can obtain the input/output signal I/O_CH0 through an output terminal of the via D0 in the logic chip, the memory chip 1 can obtain an input/output signal I/O_CH1 through an input terminal of a via D0 in the memory chip 0, the memory chip 2 can obtain an input/output signal I/O_CH4 through an input terminal of a via D0 in the memory chip 1, the memory chip 3 can obtain an input/output signal I/O_CH5 through an input terminal of a via D0 in the memory chip 2, and so on. For each memory chip, only one via in each via group needs to be connected to a drive circuit, and no data selector needs to be disposed. This can reduce the quantity of devices, and therefore reduce parasitic capacitance. However, compared with the direct connection configuration of vias in FIG. 1, the process of rotatably connecting vias (e.g., connecting the via D0 in the memory chip 0 to a via D1 in the memory chip 1) in FIG. 2 is more complex. Specifically, an interconnection structure in a horizontal direction needs to be disposed between adjacent vias in each memory chip in FIG. 2 (only one interconnection structure is marked with a five-pointed star in FIG. 2). The signal interconnection structure may be a metal interconnection line, a via, or the like. To implement the rotational connection between vias, an input signal needs to be first transmitted upward from the via D0 to a location below the via D0 in the memory chip 1 (not connected to the via D0 in the memory chip 1), and then horizontally transmitted from the location below the via D0 in the memory chip 1 to the via D1 in the memory chip 1. Therefore, in a procedure in which the input signal is sequentially transmitted from the via D0 in the logic chip to a via D0 in the memory chip 4, the input signal further needs to pass through an interconnection structure in each memory chip. There is a similar case for an output signal. This inevitably increases parasitic resistance and also increases process complexity.

In particular, in the chip stacked structures in FIG. 1 and FIG. 2, active surfaces of all the chips face upward, to be specific, different memory chips are stacked back-to-face, and the memory chip and the logic chip are also stacked back-to-face, in other words, an inactive surface of an upper chip is in contact with an active surface of a lower chip.

In conclusion, in the chip stacked structure in FIG. 1, a relatively large quantity of drive circuits and data selectors result in relatively heavy load and relatively high parasitic capacitance, and in the chip stacked structure in FIG. 2, relatively high parasitic resistance is caused by the rotational configuration. In addition, both the stacked structures in FIG. 1 and FIG. 2 have some problems, and cannot be directly applied to face-to-face stacking of chips. Specifically, if face-to-face stacking of chips needs to be further implemented, a manner is to manufacture two different types of chips through two sets of masks and respectively utilize the two different types of chips as a chip with an active surface facing upward and a chip with an active surface facing downward. In this manner, process complexity is relatively high, and costs are uncontrollable. Another manner is to manufacture an additional group of vias and connect both groups of vias to the same drive circuit in a memory chip. However, this results in complex internal tracks of the memory chip, which not only increases process complexity but also increases power consumption.

Therefore, the embodiments of the present disclosure provide a memory chip and a chip stacked structure, to implement relatively low parasitic capacitance and parasitic resistance and implement a face-to-face stacking manner.

In still another embodiment of the present disclosure, FIG. 3 is a schematic structural diagram of a memory chip 10 according to an embodiment of the present disclosure. The memory chip 10 includes 2×2 regions distributed in an array along an active surface of the memory chip 10. In subsequent descriptions, the 2×2 regions are respectively referred to as a first region 11, a second region 12, a third region 13, and a fourth region 14. In addition, there is a first axis AA' and a second axis BB' on the active surface of the memory chip 10. The first axis AA' and the second axis BB' are perpendicular to each other and intersect at the center of the active surface, the first axis AA' is parallel to a side edge of the memory chip 10, and the second axis BB' is parallel to another side edge of the memory chip 10. In particular, FIG. 3 may be considered as a schematic cross-sectional view of the memory chip 10 along the active surface.

Referring to FIG. 3, nvia groups 20 run through each region (only one via group is shown for each region in FIG. 3, and the rest is omitted), and n is a natural number. n via groups 20 in the first region 11 are symmetrical to n via groups 20 in the second region 12 with respect to the first axis AA', n via groups 20 in the third region 13 are symmetrical to n via groups 20 in the fourth region 14 with respect to the first axis AA', and the n via groups 20 in the first region 11 are symmetrical to the n via groups 20 in the fourth region 14 with respect to the second axis BB'. "n via groups 20 in the first region 11" herein are specifically "n via groups 20 running through the first region 11 in the memory chip 10", and there is a similar case for the remaining descriptions.

It should be noted that the quantity and locations of via groups 20 in each region may be adjusted based on an actual situation, but the quantities of via groups in the four regions need to be the same, and the foregoing symmetrical distribution rule needs to be followed. FIG. 4 shows three via groups 20 for each region. Certainly, there may be two, four, five, six, seven, or another quantity of via groups 20. Other cases should be adaptively understood.

In this embodiment of the present disclosure, there are four vias in each via group 20, and the same distribution rule is followed. One of the via groups 20 is taken as an example for description below.

Referring to FIG. 3, for each via group 20 (e.g., the via group 20 in the first region 11), there is a third axis CC' and a fourth axis DD', both the third axis CC' and the fourth axis DD' are located on the active surface, the third axis CC' is parallel to the first axis AA', the fourth axis DD' is parallel to the second axis BB', and the third axis CC' and the fourth axis DD' are perpendicular to each other and intersect at the center of the via group 20.

For each via group 20, the via group includes 2×2 vias distributed in an array, a first via D0 is symmetrical to a second via D1 with respect to a third axis CC', a third via D2 is symmetrical to a fourth via D3 with respect to the third axis CC', and the first via D0 is symmetrical to the fourth via D3 with respect to a fourth axis DD'.

It should be noted that each via group 20 has a corresponding third axis CC' and fourth axis DD'. To be specific, a first via D0 and a second via D1 in the same via group 20 are symmetrical to each other with respect to a third axis CC' of the via group 20, a third via D2 and a fourth via D3 in the same via group 20 are symmetrical to each other with respect to the third axis CC' of the via group 20, the first via D0 and the fourth via D3 in the same via group 20 are symmetrical to each other with respect to a fourth axis DD' of the via group 20, and the second via D1 and the third via D2 in the same via group 20 are symmetrical to each other with respect to the fourth axis DD' of the via group 20.

It should be noted that the via may also be referred to as a through silicon via (TSV), and is specifically a vertical interconnection structure penetrating through a silicon wafer/the memory chip.

It should be noted that the memory chip 10 may be specifically applied to a DRAM, an SDRAM, a DDR memory, an LPDDR memory, or the like.

It should be noted that any via runs through the memory chip in a direction (namely, a third direction) perpendicular to the active surface, and different vias in the same memory chip 10 are electrically isolated from each other.

It should be noted that in this embodiment of the present disclosure, a number sequence of the regions and a number sequence of vias in each via group 20 constitute no limitation.

In some embodiments, referring to FIG. 3 or FIG. 4, n first vias D0 in the first region 11 are symmetrical to n second vias D1 in the second region 12 with respect to the first axis AA'; n third vias D2 in the third region 13 are symmetrical to n fourth vias D3 in the fourth region 14 with respect to the first axis AA'; the n first vias D0 in the first region 11 are symmetrical to the n fourth vias D3 in the fourth region 14 with respect to the second axis BB'; and the n second vias D1 in the second region 12 are symmetrical to the n third vias D2 in the third region 13 with respect to the second axis BB'.

In some embodiments, referring to FIG. 3 or FIG. 4, n second vias D1 in the first region 11 are symmetrical to n first vias D0 in the second region 12 with respect to the first axis AA'; n fourth vias D3 in the third region 13 are symmetrical to n third vias D2 in the fourth region 14 with respect to the first axis AA'; the n second vias D1 in the first region 11 are symmetrical to the n third vias D2 in the fourth region 14 with respect to the second axis BB'; and the n first vias D0 in the second region 12 are symmetrical to the n fourth vias D3 in the third region 13 with respect to the second axis BB'.

In some embodiments, referring to FIG. 3 or FIG. 4, n third vias D2 in the first region 11 are symmetrical to n fourth vias D3 in the second region 12 with respect to the first axis AA'; n first vias D0 in the third region 13 are symmetrical to n second vias D1 in the fourth region 14 with respect to the first axis AA'; the n third vias D2 in the first region 11 are symmetrical to the second vias D1 in the fourth region 14 with respect to the first axis AA'; and the n fourth vias D3 in the second region 12 are symmetrical to the n first vias D0 in the third region 13 with respect to the second axis BB'.

In some embodiments, referring to FIG. 3 or FIG. 4, n fourth vias D3 in the first region 11 are symmetrical to n third vias D2 in the second region 12 with respect to the first axis AA'; n second vias D1 in the third region 13 are symmetrical to n first vias D0 in the fourth region 14 with respect to the first axis AA'; the n fourth vias D3 in the first region 11 are symmetrical to the n first vias D0 in the fourth region 14 with respect to the second axis BB'; and the n third vias D2 in the second region 12 are symmetrical to the n second vias D1 in the third region 13 with respect to the second axis BB'.

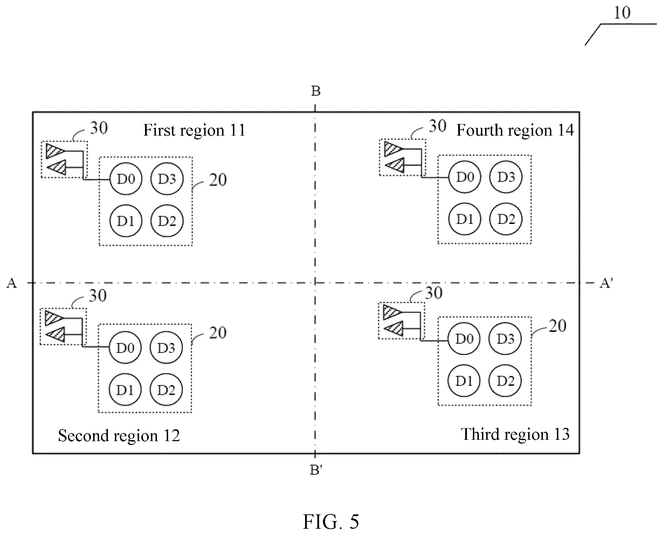

In some embodiments, referring to FIG. 5, the memory chip 10 further includes 4n first drive circuits 30. 4n vias are connected to the 4n first drive circuits 30 in one-to-one correspondence, and only one via in each via group 20 is connected to one of the first drive circuits 30. In other words, for each via group 20, a signal transmitted by only one via enters the chip or is output from the chip.

In some embodiments, the memory chip 10 further includes a positioning structure (not shown in the figure), and the positioning structure is located in a reference region to identify a location of the reference region. The reference region is one of the 2×2 regions (the first region, the second region, the third region, or the fourth region).

It should be noted that multiple chips need to be simultaneously prepared in a chip manufacturing process, and to distinguish between different regions in a chip, a positioning structure needs to be manufactured in a first region (the region may alternatively be a second region, a third region, or a fourth region, but the same region needs to be selected as a reference region for different chips) of each memory chip, so that during subsequent assembling, a location of the reference region is identified with the positioning structure, and a location of another region is determined with reference to an orientation of an active surface of the chip.

In addition, the memory chip 10 may alternatively include multiple positioning structures, and different positioning structures are located in different regions to identify absolute locations of regions in which the positioning structures are located. For example, the memory chip 10 may alternatively include four positioning structures. One positioning structure is disposed in each of the first region to the fourth region, and the four positioning structures are different from each other, so that each region can be better identified. In other words, the first region to the fourth region each may be considered as a reference region.

In this way, this embodiment of the present disclosure provides a memory chip 10. Vias in the memory chip 10 have a special symmetry, and can be directly applied to a face-to-face stacking structure, and two sets of masks or two sets of vias are not required. In addition, only one via in each via group is connected to a drive circuit, and no data selector needs to be disposed for via selection, to reduce the quantity of devices, so that compared with the memory chip in FIG. 1, the memory chip reduces parasitic capacitance, reduces a circuit area, and reduces chip manufacturing costs. During subsequent formation of a stacked structure, the memory chip 10 can further reduce parasitic resistance compared with the memory chip in FIG. 2 (for a specific reason, reference is made to subsequent descriptions).

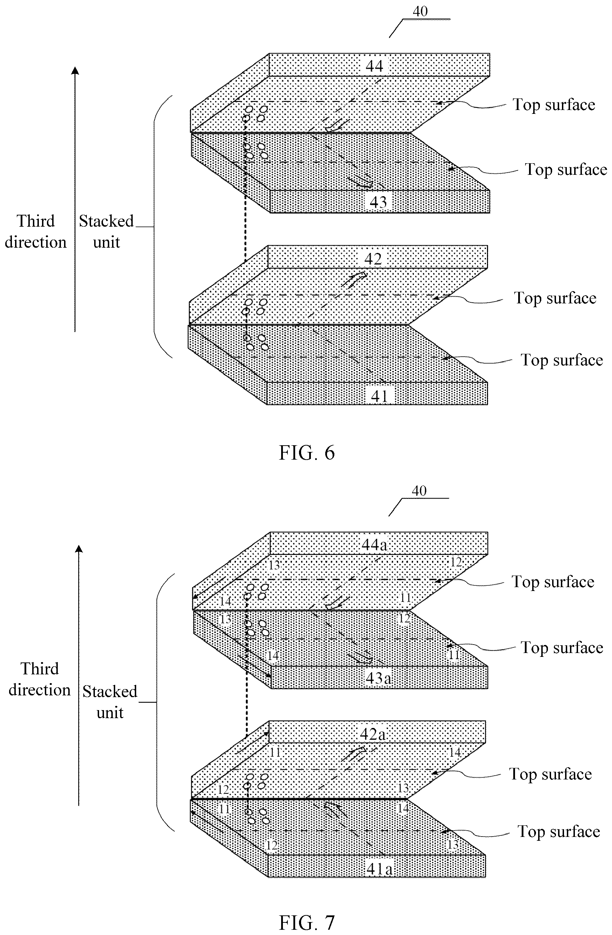

In still another embodiment of the present disclosure, FIG. 6 shows a chip stacked structure 40 according to an embodiment of the present disclosure. The chip stacked structure 40 includes at least one stacked unit, each stacked unit includes a first memory chip 41, a second memory chip 42, a third memory chip 43, and a fourth memory chip 44 sequentially stacked in a third direction, the third direction is perpendicular to an active surface of each of the memory chips, and each of the first memory chip 41, the second memory chip 42, the third memory chip 43, and the fourth memory chip 44 is the foregoing memory chip 10. The first memory chip 41 and the second memory chip 42 are stacked in a face-to-face manner, to be specific, a top surface (namely, an active surface) of the first memory chip 41 is adjacent to a top surface of the second memory chip 42. The second memory chip 42 and the third memory chip 43 are stacked in a back-to-back manner, to be specific, a back surface (namely, an inactive surface) of the second memory chip 42 is adjacent to a back surface of the third memory chip 43. The third memory chip 43 and the fourth memory chip 44 are stacked in a face-to-face manner, to be specific, a top surface of the third memory chip 43 is adjacent to a top surface of the fourth memory chip 44.

In a possibility, in two memory chips connected face-to-face, vias aligned with each other in the third direction are connected through hybrid bonding structures (also referred to as bonding pillars); and in two memory chips connected back-to-back, vias aligned with each other in the third direction are connected through conductive bumps (UBumps, also referred to as micro bumps).

In another possibility, in two memory chips connected face-to-face or two memory chips connected back-to-back, vias aligned with each other in the third direction are connected through hybrid bonding structures. To be specific, vias aligned with each other in the third direction in two memory chips connected face-to-face are connected through hybrid bonding structures; and vias aligned with each other in the third direction in two memory chips connected back-to-back are also connected through hybrid bonding structures.

In still another possibility, in two memory chips connected face-to-face or two memory chips connected back-to-back, vias aligned with each other in the third direction are connected through conductive bumps. To be specific, vias aligned with each other in the third direction in two memory chips connected face-to-face are connected through conductive bumps; and vias aligned with each other in the third direction in two memory chips connected back-to-back are also connected through conductive bumps.

It should be noted that compared with the conductive bump, a face-to-face connection employing the hybrid bonding structure can make adjacent memory chips adhere more closely, with basically no gaps, to significantly reduce the height of the chip stacked structure. This is also one of the advantages of face-to-face stacking. Certainly, two memory chips connected back-to-back may alternatively be connected through hybrid bonding structures. However, connection performance achieved when the hybrid bonding structures are employed is poorer than that achieved when a face-to-face connection is employed.

In a specific embodiment, referring to FIG. 7, a first region 11 in a first memory chip 41a, a second region 12 in a second memory chip 42a, a third region 13 in a third memory chip 43a, and a fourth region 14 in a fourth memory chip 44a are aligned with each other in the third direction;
a second region 12 in the first memory chip 41a, a first region 11 in the second memory chip 42a, a fourth region 14 in the third memory chip 43a, and a third region 13 in the fourth memory chip 44a are aligned with each other in the third direction;
a third region 13 in the first memory chip 41a, a fourth region 14 in the second memory chip 42a, a first region 11 in the third memory chip 43a, and a second region 12 in the fourth memory chip 44a are aligned with each other in the third direction; and
a fourth region 14 in the first memory chip 41a, a third region 13 in the second memory chip 42a, a second region 12 in the third memory chip 43a, and a first region 11 in the fourth memory chip 44a are aligned with each other in the third direction.

It should be noted that the memory chip may be divided into an upper transmission region and a lower transmission region, and all arrows in FIG. 7 are located in the upper transmission region of the memory chip.

To be specific, after the first memory chip 41a is placed, the second memory chip 42a needs to be placed on the first memory chip 41a in a face-to-face manner, and locations of an upper transmission region in the second memory chip 42a and a lower transmission region in the first memory chip 41a in the third direction are approximately the same. Then the third memory chip 43a is placed on the second memory chip 42a in a back-to-back manner, and locations of an upper transmission region in the third memory chip 43a and the upper transmission region in the second memory chip 42a in the third direction are approximately the same, but locations of specific devices in the two memory chips do not overlap (a mirror relationship is specifically presented). Then the fourth memory chip 44a is placed on the third memory chip 43a in a face-to-face manner, and locations of an upper transmission region in the fourth memory chip 44a and a lower transmission region in the third memory chip 43a in the third direction are approximately the same. In this way, one stacked unit is formed by the first memory chip 41a, the second memory chip 42a, the third memory chip 43a, and the fourth memory chip 44a.

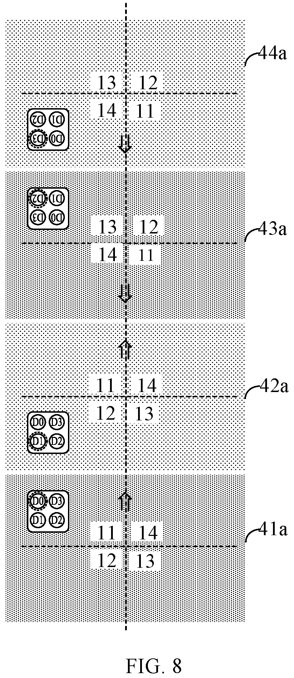

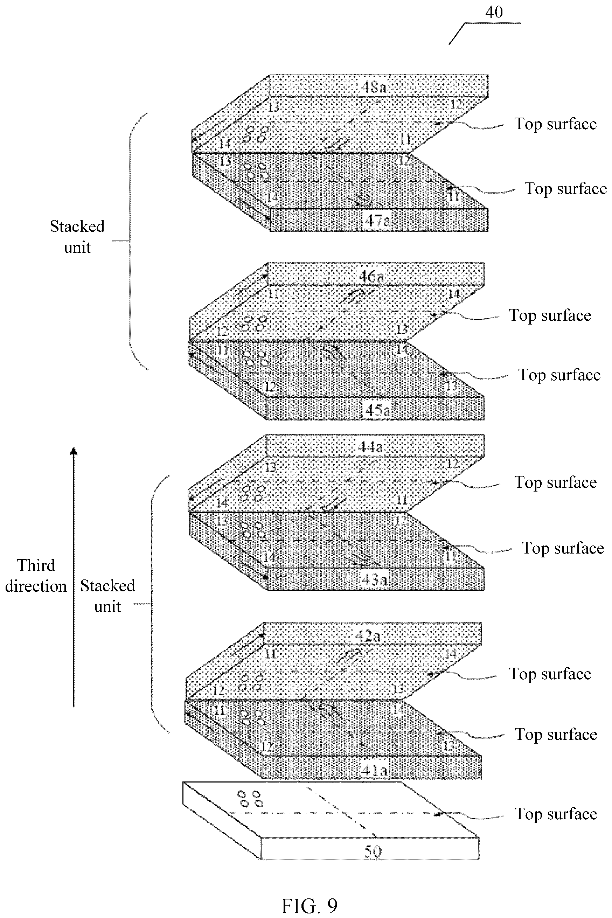

It should be further noted that the chip stacked structure 40 may include multiple stacked units. Referring to FIG. 9, after the first stacked unit is formed, a fifth memory chip 45a is placed on the fourth memory chip 44a in a back-to-back manner, and locations of an upper transmission region in the fifth memory chip 45a and the upper transmission region in the fourth memory chip 44a in the third direction are approximately the same, but locations of specific devices in the two memory chips do not overlap (a mirror relationship is specifically presented). Then a sixth memory chip 46a is placed on the fifth memory chip 45a in a face-to-face manner, and it is further necessary to control locations of an upper transmission region in the sixth memory chip 46a and a lower transmission region in the fifth memory chip 45a in the third direction to be approximately the same. Then a seventh memory chip 47a is placed on the sixth memory chip 46a in a back-to-back manner, and locations of an upper transmission region in the seventh memory chip 47a and the upper transmission region in the sixth memory chip 46a in the third direction are approximately the same, but locations of specific devices in the two memory chips do not overlap (a mirror relationship is specifically presented). Then an eighth memory chip 48a is placed on the seventh memory chip 47a in a face-to-face manner, and locations of an upper transmission region in the eighth memory chip 48a and a lower transmission region in the seventh memory chip 47a in the third direction are approximately the same. In this way, one stacked unit is formed by the fifth memory chip 45a, the sixth memory chip 46a, the seventh memory chip 47a, and the eighth memory chip 48a. In other words, the fifth memory chip 45a of the second stacked unit may also be considered as the first memory chip 41a of the first stacked unit, the sixth memory chip 46a of the second stacked unit may also be considered as the second memory chip 42a of the first stacked unit, the seventh memory chip 47a of the second stacked unit may also be considered as the third memory chip 43a of the first stacked unit, and the eighth memory chip 48a of the second stacked unit may also be considered as the fourth memory chip 44a of the first stacked unit. FIG. 8 is a schematic diagram of a flattened active surface of each chip in the stacked unit shown in FIG. 7. In particular, four vias that a dotted line runs through in FIG. 7 are reflected as four vias circled by dotted lines in FIG. 8.

In an aspect, referring to FIG. 8, for vias in the first region 11 in the first memory chip 41a, there are the following location characteristics:
(1) n first vias D0 in the first region 11 in the first memory chip 41a, n second vias D1 in the second region 12 in the second memory chip 42a, n third vias D2 in the third region 13 in the third memory chip 43a, and n fourth vias D3 in the fourth region 14 in the fourth memory chip 44a are aligned with each other in the third direction.
(2) n second vias D1 in the first region 11 in the first memory chip 41a, n first vias D0 in the second region 12 in the second memory chip 42a, n fourth vias D3 in the third region 13 in the third memory chip 43a, and n third vias D2 in the fourth region 14 in the fourth memory chip 44a are aligned with each other in the third direction.
(3) n third vias D2 in the first region 11 in the first memory chip 41a, n fourth vias D3 in the second region 12 in the second memory chip 42a, n first vias D0 in the third region 13 in the third memory chip 43a, and n second vias D1 in the fourth region 14 in the fourth memory chip 44a are aligned with each other in the third direction.
(4) n fourth vias D3 in the first region 11 in the first memory chip 41a, n third vias D2 in the second region 12 in the second memory chip 42a, n second vias D1 in the third region 13 in the third memory chip 43a, and n first vias D0 in the fourth region 14 in the fourth memory chip 44a are aligned with each other in the third direction.

In particular, only one via group in one region is shown as an example in FIG. 7 and FIG. 8. However, actually, there are multiple via groups in each region. In addition, via groups in different regions have similar alignment characteristics. Alignment of the remaining vias is not shown. For adaptive understanding, reference is made to the following text descriptions, FIG. 7, and FIG. 8

In another aspect, for vias in the second region 12 in the first memory chip 41a, there are the following location characteristics:
(1) n first vias D0 in the second region 12 in the first memory chip 41a, n second vias D1 in the first region 11 in the second memory chip 42a, n third vias D2 in the fourth region 14 in the third memory chip 43a, and n fourth vias D3 in the third region 13 in the fourth memory chip 44a are aligned with each other in the third direction.
(2) n second vias D1 in the second region 12 in the first memory chip 41a, n first vias D0 in the first region 11 in the second memory chip 42a, n fourth vias D3 in the fourth region 14 in the third memory chip 43a, and n third vias D2 in the third region 13 in the fourth memory chip 44a are aligned with each other in the third direction.
(3) n third vias D2 in the second region 12 in the first memory chip 41a, n fourth vias D3 in the first region 11 in the second memory chip 42a, n first vias D0 in the fourth region 14 in the third memory chip 43a, and n second vias D1 in the third region 13 in the fourth memory chip 44a are aligned with each other in the third direction.
(4) n fourth vias D3 in the second region 12 in the first memory chip 41a, n third vias D2 in the first region 11 in the second memory chip 42a, n second vias D1 in the fourth region 14 in the third memory chip 43a, and n first vias D0 in the third region 13 in the fourth memory chip 44a are aligned with each other in the third direction.

In still another aspect, for vias in the third region 13 in the first memory chip 41a, there are the following location characteristics:
(1) n first vias D0 in the third region 13 in the first memory chip 41a, n second vias D1 in the fourth region 14 in the second memory chip 42a, n third vias D2 in the first region 11 in the third memory chip 43a, and n fourth vias D3 in the second region 12 in the fourth memory chip 44a are aligned with each other in the third direction.
(2) n second vias D1 in the third region 13 in the first memory chip 41a, n first vias D0 in the fourth region 14 in the second memory chip 42a, n fourth vias D3 in the first region 11 in the third memory chip 43a, and n third vias D2 in the second region 12 in the fourth memory chip 44a are aligned with each other in the third direction.
(3) n third vias D2 in the third region 13 in the first memory chip 41a, n fourth vias D3 in the fourth region 14 in the second memory chip 42a, n first vias D0 in the first region 11 in the third memory chip 43a, and n second vias D1 in the second region 12 in the fourth memory chip 44a are aligned with each other in the third direction.
(4) n fourth vias D3 in the third region 13 in the first memory chip 41a, n third vias D2 in the fourth region 14 in the second memory chip 42a, n second vias D1 in the first region 11 in the third memory chip 43a, and n first vias D0 in the second region 12 in the fourth memory chip 44a are aligned with each other in the third direction.

In yet another aspect, for vias in the fourth region 14 in the first memory chip 41a, there are the following location characteristics:
(1) n first vias D0 in the fourth region 14 in the first memory chip 41a, n second vias D1 in the third region 13 in the second memory chip 42a, n third vias D2 in the second region 12 in the third memory chip 43a, and n fourth vias D3 in the first region 11 in the fourth memory chip 44a are aligned with each other in the third direction.
(2) n second vias D1 in the fourth region 14 in the first memory chip 41a, n first vias D0 in the third region 13 in the second memory chip 42a, n fourth vias D3 in the second region 12 in the third memory chip 43a, and n third vias D2 in the first region 11 in the fourth memory chip 44a are aligned with each other in the third direction.
(3) n third vias D2 in the fourth region 14 in the first memory chip 41a, n fourth vias D3 in the third region 13 in the second memory chip 42a, n first vias D0 in the second region 12 in the third memory chip 43a, and n second vias D1 in the first region 11 in the fourth memory chip 44a are aligned with each other in the third direction.
(4) n fourth vias D3 in the fourth region 14 in the first memory chip 41a, n third vias D2 in the third region 13 in the second memory chip 42a, n second vias D1 in the second region 12 in the third memory chip 43a, and n first vias D0 in the first region 11 in the fourth memory chip 44a are aligned with each other in the third direction.

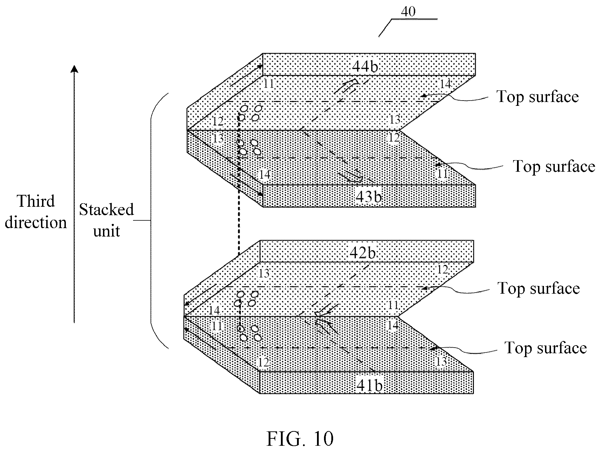

In this way, FIG. 7 to FIG. 9 show a specific chip stacking manner. FIG. 10 to FIG. 12 show another specific chip stacking manner. Details descriptions are as follows.

Referring to FIG. 10, a first region 11 in a first memory chip 41b, a fourth region 14 in a second memory chip 42b, a third region 13 in a third memory chip 43b, and a second region 12 in a fourth memory chip 44b are aligned with each other in the third direction;
a second region 12 in the first memory chip 41b, a third region 13 in the second memory chip 42b, a fourth region 14 in the third memory chip 43b, and a first region 11 in the fourth memory chip 44b are aligned with each other in the third direction;
a third region 13 in the first memory chip 41b, a second region 12 in the second memory chip 42b, a first region 11 in the third memory chip 43b, and a fourth region 14 in the fourth memory chip 44b are aligned with each other in the third direction; and
a fourth region 14 in the first memory chip 41b, a first region 11 in the second memory chip 42b, a second region 12 in the third memory chip 43b, and a third region 13 in the fourth memory chip 44b are aligned with each other in the third direction.

Similarly, all arrows in FIG. 10 are located in the upper transmission region of the memory chip.

To be specific, locations of an upper transmission region in the second memory chip 42b and an upper transmission region in the first memory chip 41b in the third direction are approximately the same, but locations of specific devices in the two memory chips do not overlap (a mirror relationship is specifically presented). Locations of an upper transmission region in the third memory chip 43b and a lower transmission region in the second memory chip 42b in the third direction are approximately the same. Locations of an upper transmission region in the fourth memory chip 44b and the upper transmission region in the third memory chip 43b in the third direction are approximately the same, but locations of specific devices in the two memory chips do not overlap (a mirror relationship is specifically presented).

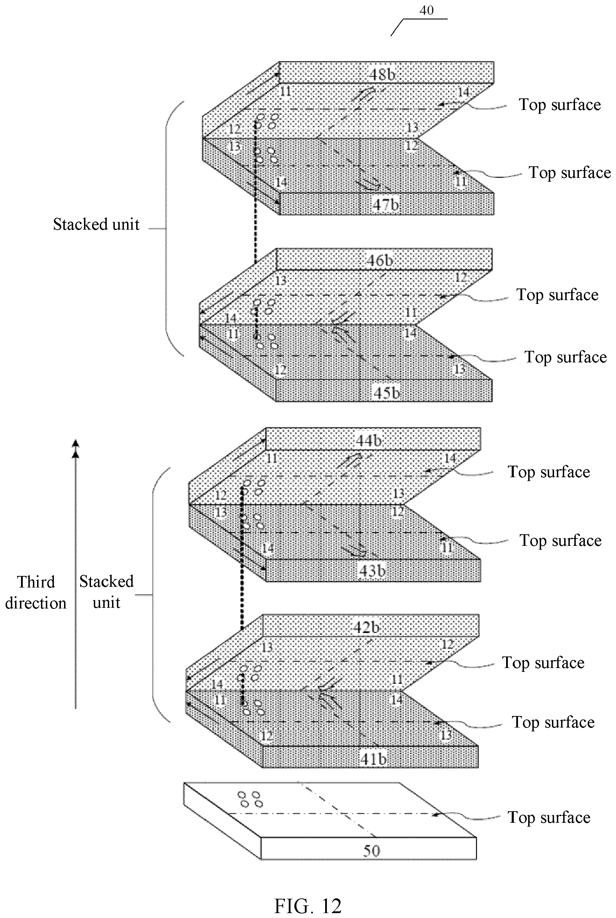

Similarly, there may be multiple stacked units. Referring to FIG. 12, after the first stacked unit is formed, a fifth memory chip 45b to an eighth memory chip 48b continue to be stacked. A location of an upper transmission region in the fifth memory chip 45b and a lower transmission region in the fourth memory chip 44b in the third direction are approximately the same. Locations of an upper transmission region in the sixth memory chip 46b and the upper transmission region in the fifth memory chip 45b in the third direction are approximately the same, but locations of specific devices in the two memory chips do not overlap (a mirror relationship is specifically presented). Locations of an upper transmission region in the seventh memory chip 47b and a lower transmission region in the sixth memory chip 46b in the third direction are approximately the same. Locations of an upper transmission region in the eighth memory chip 48b and the upper transmission region in the seventh memory chip 47b in the third direction are approximately the same, but locations of specific devices in the two memory chips do not overlap (a mirror relationship is specifically presented).

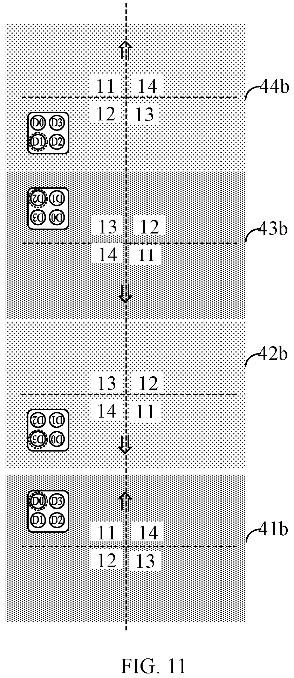

FIG. 11 is a schematic diagram of a flattened active surface of each chip in the stacked unit shown in FIG. 10. In particular, four vias that a dotted line runs through in FIG. 10 are reflected as four vias circled by dotted lines in FIG. 11.

In an aspect, referring to FIG. 11, for vias in the first region 11 in the first memory chip 41b, there are the following location characteristics:
(1) n first vias D0 in the first region 11 in the first memory chip 41b, n fourth vias D3 in the fourth region 14 in the second memory chip 42b, n third vias D2 in the third region 13 in the third memory chip 43b, and n second vias D1 in the second region 12 in the fourth memory chip 44b are aligned with each other in the third direction.
(2) n second vias D1 in the first region 11 in the first memory chip 41b, n third vias D2 in the fourth region 14 in the second memory chip 42b, n fourth vias D3 in the third region 13 in the third memory chip 43b, and n first vias D0 in the second region 12 in the fourth memory chip 44b are aligned with each other in the third direction.
(3) n third vias D2 in the first region 11 in the first memory chip 41b, n second vias D1 in the fourth region 14 in the second memory chip 42b, n first vias D0 in the third region 13 in the third memory chip 43b, and n fourth vias D3 in the second region 12 in the fourth memory chip 44b are aligned with each other in the third direction.
(4) n fourth vias D3 in the first region 11 in the first memory chip 41b, n first vias D0 in the fourth region 14 in the second memory chip 42b, n second vias D1 in the third region 13 in the third memory chip 43b, and n third vias D2 in the second region 12 in the fourth memory chip 44b are aligned with each other in the third direction.

In particular, only one via group in one region is shown as an example in FIG. 10 and FIG. 11. However, actually, there are multiple via groups in each region. In addition, via groups in different regions have similar alignment characteristics. Alignment of the remaining vias is not shown. For adaptive understanding, reference is made to the following text descriptions, FIG. 10, and FIG. 11

In another aspect, for vias in the second region 12 in the first memory chip 41b, there are the following location characteristics:
(1) n first vias D0 in the second region 12 in the first memory chip 41b, n fourth vias D3 in the third region 13 in the second memory chip 42b, n third vias D2 in the fourth region 14 in the third memory chip 43b, and n second vias D1 in the first region 11 in the fourth memory chip 44b are aligned with each other in the third direction.
(2) n second vias D1 in the second region 12 in the first memory chip 41b, n third vias D2 in the third region 13 in the second memory chip 42b, n fourth vias D3 in the fourth region 14 in the third memory chip 43b, and n first vias D0 in the first region 11 in the fourth memory chip 44b are aligned with each other in the third direction.
(3) n third vias D2 in the second region 12 in the first memory chip 41b, n second vias D1 in the third region 13 in the second memory chip 42b, n first vias D0 in the fourth region 14 in the third memory chip 43b, and n fourth vias D3 in the first region 11 in the fourth memory chip 44b are aligned with each other in the third direction.
(4) n fourth vias D3 in the second region 12 in the first memory chip 41b, n first vias D0 in the third region 13 in the second memory chip 42b, n second vias D1 in the fourth region 14 in the third memory chip 43b, and n third vias D2 in the first region 11 in the fourth memory chip 44b are aligned with each other in the third direction.

In still another aspect, for vias in the third region 13 in the first memory chip 41b, there are the following location characteristics:
(1) n first vias D0 in the third region 13 in the first memory chip 41b, n fourth vias D3 in the second region 12 in the second memory chip 42b, n third vias D2 in the first region 11 in the third memory chip 43b, and n second vias D1 in the fourth region 14 in the fourth memory chip 44b are aligned with each other in the third direction.
(2) n second vias D1 in the third region 13 in the first memory chip 41b, n third vias D2 in the second region 12 in the second memory chip 42b, n fourth vias D3 in the first region 11 in the third memory chip 43b, and n first vias D0 in the fourth region 14 in the fourth memory chip 44b are aligned with each other in the third direction.
(3) n third vias D2 in the third region 13 in the first memory chip 41b, n second vias D1 in the second region 12 in the second memory chip 42b, n first vias D0 in the first region 11 in the third memory chip 43b, and n fourth vias D3 in the fourth region 14 in the fourth memory chip 44b are aligned with each other in the third direction.
(4) n fourth vias D3 in the third region 13 in the first memory chip 41b, n first vias D0 in the second region 12 in the second memory chip 42b, n second vias D1 in the first region 11 in the third memory chip 43b, and n third vias D2 in the fourth region 14 in the fourth memory chip 44b are aligned with each other in the third direction.

In yet another aspect, for vias in the fourth region 14 in the first memory chip 41b, there are the following location characteristics:
(1) n first vias D0 in the fourth region 14 in the first memory chip 41b, n fourth vias D3 in the first region 11 in the second memory chip 42b, n third vias D2 in the second region 12 in the third memory chip 43b, and n second vias D1 in the third region 13 in the fourth memory chip 44b are aligned with each other in the third direction.
(2) n second vias D1 in the fourth region 14 in the first memory chip 41b, n third vias D2 in the first region 11 in the second memory chip 42b, n fourth vias D3 in the second region 12 in the third memory chip 43b, and n first vias D0 in the third region 13 in the fourth memory chip 44b are aligned with each other in the third direction.
(3) n third vias D2 in the fourth region 14 in the first memory chip 41b, n second vias D2 in the first region 11 in the second memory chip 42b, n first vias D0 in the second region 12 in the third memory chip 43b, and n fourth vias D3 in the third region 13 in the fourth memory chip 44b are aligned with each other in the third direction.
(4) n fourth vias D3 in the fourth region 14 in the first memory chip 41b, n first vias D0 in the first region 11 in the second memory chip 42b, n second vias D1 in the second region 12 in the third memory chip 43b, and n third vias D2 in the third region 13 in the fourth memory chip 44b are aligned with each other in the third direction.

In this way, a chip stacked structure in FIG. 10 to FIG. 12 also meets a usage requirement.

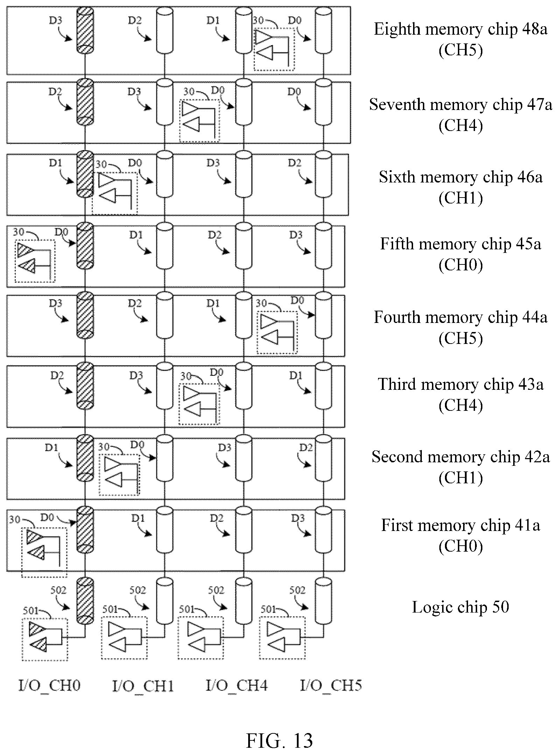

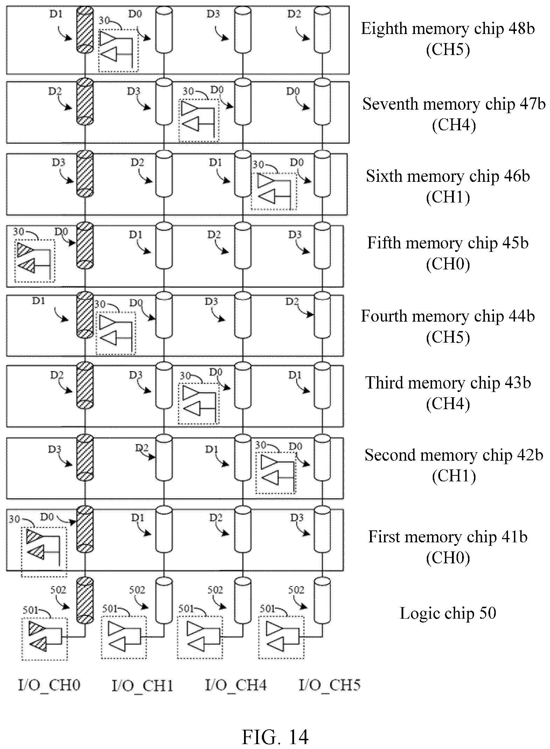

In some embodiments, FIG. 13 and FIG. 14 are schematic diagrams of signal transmission in the chip stacked structure 40. In particular, FIG. 13 is shown for the chip stacked structure shown in FIG. 7, and FIG. 14 is shown for the chip stacked structure shown in FIG. 10. In particular, in the following descriptions, the first memory chip 41 may be the first memory chip 41a or the first memory chip 41b, and there is a similar case for another memory chip.

As shown in FIG. 13 or FIG. 14, each memory chip further includes 4n first drive circuits 30 (only one first drive circuit is shown for each memory chip in FIG. 13). In each memory chip, 4n first drive circuits 30 are connected to first terminals of 4n first vias D0 in one-to-one correspondence. The first terminals are located on an active surface of the memory chip.

In other words, in each of the first memory chip 41, the second memory chip 42, the third memory chip 43, and the fourth memory chip 44, first drive circuits 30 are connected to first vias D0, in other words, the exactly same structure is employed for the first memory chip 41, the second memory chip 42, the third memory chip 43, and the fourth memory chip 44.

In some embodiments, referring to FIG. 9 and FIG. 12, the chip stacked structure 40 further includes a logic chip 50. The first stacked unit is stacked on the logic chip 50 in the third direction, and each of the remaining stacked units is stacked on a previous stacked unit in the third direction. Herein, the first memory chip and the logic chip 50 are stacked in a back-to-face manner, or the first memory chip and the logic chip 50 are stacked in a back-to-back manner.

Referring to FIG. 13 and FIG. 14, the logic chip 50 includes 16n fifth vias 502 and 16n second drive circuits 501.

In the 16n fifth vias 502, 4n fifth vias 502 are aligned with the 4n first vias D0 in the first memory chip 41 in the third direction in one-to-one correspondence, 4n fifth vias 502 are aligned with the 4n second vias D1 in the first memory chip 41 in the third direction in one-to-one correspondence, 4n fifth vias 502 are aligned with the 4n third vias D2 in the first memory chip 41 in the third direction in one-to-one correspondence, and 4n fifth vias 502 are aligned with the 4n fourth vias D3 in the first memory chip 41 in the third direction in one-to-one correspondence.

The 16n second drive circuits 501 are connected to first terminals of the 16n fifth vias 502 in one-to-one correspondence, and the first terminals are located on an active surface of the logic chip 50.

In other words, vias in the logic chip 50 are arranged at the same locations as those in the foregoing memory chip 10, but each via in the logic chip 50 is connected to one drive circuit.

It should be noted that FIG. 13 and FIG. 14 are only schematic diagrams of abstracted circuits, a drive circuit is simply placed next to a via connected to the drive circuit, and no connection relationship is specifically drawn. For adaptive understanding, reference is made to the text descriptions.

The chip stacked structure 40 further includes 16n electrical paths, and one fifth via, at least one first via D0, at least one second via D1, at least one third via D2, and at least one fourth via D3 aligned with each other in the third direction are connected to form one electrical path.

It should be noted that one fifth via 502, m first vias D0, m second vias D1, m third vias D2, and m fourth vias D3 aligned with each other in the third direction are connected to form one electrical path if the chip stacked structure 40 includes m stacked units, and m is a positive integer.

In this way, referring to FIG. 13 or FIG. 14, an input/output signal I/O_CH0 on a channel CH0 is transmitted through "a via D0 in the logic chip -- a via D0 in a memory chip 0a via D1 in a memory chip 1 -- a via D2 in a memory chip 2 -- a via D3 in a memory chip 3 -- a via D0 in a memory chip 4 -- a via D1 in a memory chip 5 -- a via D2 in a memory chip 6 -- a via D3 in a memory chip 7", and there is a similar case for the remaining signals. In this case, the first memory chip 41 may obtain the input/output signal I/O_CH0 through an input terminal of the via D0 of the first memory chip 41, the second memory chip 42 may obtain an input/output signal I/O_CH1 through an input terminal of the via D0 of the second memory chip 42, the third memory chip 43 may obtain an input/output signal I/O_CH4 through an input terminal of the via D0 of the third memory chip 43, the fourth memory chip 44 may obtain an input/output signal I/O_CH5 through an input terminal of the via D0 of the fourth memory chip 44, and so on. In other words, referring to FIG. 13 or FIG. 14, for the chip stacked structure 40, from a physical perspective, the vias are still in a direct connection configuration. However, from a perspective of absolute locations of the vias on the active surface, it may also be considered that the vias are in a functional rotational configuration, in other words, a signal transmission effect (that is, a rotational transmission effect such as the via D0 - the via D1 - the via D2 - the via D3...) similar to that in FIG. 2 is implemented through the physical direct connection configuration. Briefly, a physical spiral structure is required by the chip stacked structure in FIG. 2, and a horizontal interconnection structure necessarily exists. The chip stacked structure in FIG. 13 or FIG. 14 is a directly connected structure physically, without requiring a horizontal interconnection structure, so that parasitic resistance is significantly reduced, and a transmission speed and transmission performance are significantly improved.

In an embodiment, a general preparation process of the chip stacked structure 40 is as follows.

In the step of S801, a wafer is provided.

In the step of S802, multiple chip regions are planned in the wafer, and a main structure of the foregoing memory chip is formed in each chip region.

In the step of S803, the wafer is cut to obtain multiple memory chips.

In the step of S804, 4m memory chips and one logic chip are aligned in a third direction (for an alignment rule, reference is made to the foregoing descriptions), and conductive bumps and/or hybrid connection structures are formed between two chips to form one chip stacked structure 40.

In another embodiment, a general preparation process of the chip stacked structure 40 is as follows.

In the step of S901, 4m wafers are provided.

In the step of S902, multiple chip regions are planned in each wafer, and a main structure of the foregoing memory chip is formed in each chip region.

In the step of S903, the 4m wafers are aligned in a third direction (for an alignment rule, reference is made to the foregoing descriptions), and conductive bumps and/or hybrid connection structures are formed between two adjacent wafers.

It should be noted that in two adjacent wafers, there are multiple pairs of memory chips aligned with each other in the third direction, and conductive bumps and/or hybrid connection structures need to be formed for each pair of memory chips aligned with each other in the third direction.

In the step of S904, the 4m wafers are cut to obtain multiple pre-stacked structures.

In the step of S905, the multiple pre-stacked structures and multiple logic chips are correspondingly assembled to form multiple chip stacked structures 40.

In still another embodiment, a general preparation process of the chip stacked structure 40 is as follows.

In the step of S1001, 4m+1 wafers are provided.

In the step of S1002, multiple chip regions are planned in each wafer, and a main structure of the foregoing memory chip is formed in each chip region in the 4m wafers; and a main structure of the foregoing logic chip is formed in each chip region in one wafer.

In the step of S 1003, the 4m+1 wafers are aligned in a third direction (for an alignment rule, reference is made to the foregoing descriptions), and conductive bumps and/or hybrid connection structures are formed between two adjacent wafers.

It should be noted that in two adjacent wafers, there are multiple pairs of memory chips aligned with each other in the third direction, and conductive bumps and/or hybrid connection structures need to be formed for each pair of memory chips aligned with each other in the third direction.

In the step of S 1004, the 4m+1 wafers are cut to obtain multiple chip stacked structures 40.

It can be learned from the foregoing descriptions that the memory chip provided in the embodiments of the present disclosure reduces the quantity of disposed drive circuits and data selectors, so that parasitic capacitance is reduced. In addition, a chip stacked structure formed by memory chips implements a rotational transmission effect of a signal with a direct connection configuration of vias, and further reduces parasitic resistance. It is found through simulation experiments that the chip stacked structure provided in the embodiments of the present disclosure has parasitic capacitance approximately 7% lower than that shown in FIG. 2, and has parasitic resistance approximately 95% lower than that shown in FIG. 2, so that more chips can be stacked, and signal transmission quality is better.

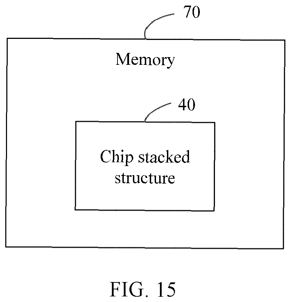

In yet another embodiment of the present disclosure, FIG. 15 is a schematic structural diagram of composition of a memory 70 according to an embodiment of the present disclosure. As shown in FIG. 15, the memory 70 includes at least the foregoing chip stacked structure 40.

The foregoing descriptions are merely example embodiments of the present disclosure, and are not intended to limit the protection scope of the present disclosure. It should be noted that in the present disclosure, the terms "include", "comprise", or any other variant thereof are intended to cover non-exclusive inclusion, so that a procedure, method, article, or apparatus including a series of elements includes not only those elements but also other elements not expressly listed, or further includes elements inherent to such a procedure, method, article, or apparatus. An element preceded by "includes a..." does not, without more constraints, preclude the presence of additional identical elements in the procedure, method, article, or apparatus including the element. The sequence numbers of the foregoing embodiments of the present disclosure are merely for the purpose of description, and are not intended to indicate priorities of the embodiments. The methods disclosed in the several method embodiments provided in the present disclosure may be randomly combined when there is no conflict, to obtain new method embodiments. The features disclosed in the several product embodiments provided in the present disclosure may be randomly combined when there is no conflict, to obtain new product embodiments. The features disclosed in the several method or device embodiments provided in the present disclosure may be randomly combined when there is no conflict, to obtain new method embodiments or new device embodiments. The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

### Industrial applicability

Embodiments of the present disclosure provide a memory chip, a chip stacked structure, and a memory, to reduce the quantity of disposed drive circuits and data selectors, so that parasitic capacitance is reduced. In addition, a chip stacked structure formed by memory chips implements a rotational transmission effect of a signal with a direct connection configuration of vias, and further reduces parasitic resistance.

## Claims

1. A memory chip (10), comprising 2×2 regions distributed in an array along an active surface of the memory chip (10), n via groups (20) running through each of the regions, and n being a natural number,
n via groups (20) in a first region (11) being symmetrical to n via groups (20) in a second region (12) with respect to a first axis (AA'), n via groups (20) in a third region (13) being symmetrical to n via groups (20) in a fourth region (14) with respect to the first axis (AA'), and the n via groups (20) in the first region (11) being symmetrical to the n via groups (20) in the fourth region (14) with respect to a second axis (BB'), both the first axis (AA') and the second axis (BB') being located on the active surface, and the first axis (AA') and the second axis (BB') being perpendicular to each other and intersecting at a center of the active surface;
for each of the via groups (20), the via group comprising 2×2 vias distributed in an array, a first via (D0) being symmetrical to a second via (D1) with respect to a third axis (CC'), a third via (D2) being symmetrical to a fourth via (D3) with respect to the third axis (CC'), and the first via (D0) being symmetrical to the fourth via (D3) with respect to a fourth axis (DD'), both the third axis (CC') and the fourth axis (DD') being located on the active surface, and the third axis (CC') and the fourth axis (DD') being perpendicular to each other and intersecting at a center of the via group (20); and
the first axis (AA') and third axes (CC') of the via groups (20) being parallel to a first side edge of the memory chip (10), and the second axis (BB') and fourth axes (DD') of the via groups (20) being parallel to a second side edge of the memory chip (10).

2. The memory chip (10) according to claim 1, wherein
n first vias (D0) in the first region (11) are symmetrical to n second vias (D1) in the second region (12) with respect to the first axis (AA');
n third vias (D2) in the third region (13) are symmetrical to n fourth vias (D3) in the fourth region (14) with respect to the first axis (AA'); and
the n first vias (D0) in the first region (11) are symmetrical to the n fourth vias (D3) in the fourth region (14) with respect to the second axis (BB').

3. The memory chip (10) according to claim 2, wherein
n second vias (D1) in the first region (11) are symmetrical to n first vias (D0) in the second region (12) with respect to the first axis (AA');
n fourth vias (D3) in the third region (13) are symmetrical to n third vias (D2) in the fourth region (14) with respect to the first axis (AA'); and
the n second vias (D1) in the first region (11) are symmetrical to the n third vias (D2) in the fourth region (14) with respect to the second axis (BB').

4. The memory chip (10) according to claim 3, wherein
n third vias (D2) in the first region (11) are symmetrical to n fourth vias (D3) in the second region (12) with respect to the first axis (AA');
n first vias (D0) in the third region (13) are symmetrical to n second vias (D1) in the fourth region (14) with respect to the first axis (AA'); and
the n third vias (D2) in the first region (11) are symmetrical to the n second vias (D1) in the fourth region (14) with respect to the first axis (AA').

5. The memory chip (10) according to claim 4, wherein
n fourth vias (D3) in the first region (11) are symmetrical to n third vias (D2) in the second region (12) with respect to the first axis (AA');
n second vias (D1) in the third region (13) are symmetrical to n first vias (D0) in the fourth region (14) with respect to the first axis (AA'); and
the n fourth vias (D3) in the first region (11) are symmetrical to the n first vias (D0) in the fourth region (14) with respect to the second axis (BB').

6. The memory chip (10) according to any one of claims 1 to 5, wherein
any one of the vias runs through the memory chip (10) in a direction perpendicular to the active surface, and different vias in a same memory chip (10) are electrically isolated from each other.

7. The memory chip (10) according to any one of claims 1 to 6, further comprising 4n first drive circuits (30),
4n vias being connected to 4n first drive circuits (30) in one-to-one correspondence, and only one via in each via group (20) being connected to one of the first drive circuits (30).

8. The memory chip (10) according to any one of claims 1 to 7, further comprising a positioning structure,
the positioning structure being located in a reference region to identify a location of the reference region, the reference region being one of the 2×2 regions.

9. A chip stacked structure (40), comprising at least one stacked unit, each stacked unit comprising a first memory chip (41, 41a, 41b), a second memory chip (42, 42a, 42b), a third memory chip (43, 43a, 43b), and a fourth memory chip (44, 44a, 44b) sequentially stacked in a third direction, the third direction being perpendicular to an active surface of each of the memory chips, and each of the first memory chip (41, 41a, 41b), the second memory chip (42, 42a, 42b), the third memory chip (43, 43a, 43b), and the fourth memory chip (44, 44a, 44b) being the memory chip (10) according to any one of claims 1 to 7,
the first memory chip (41, 41a, 41b) and the second memory chip (42, 42a, 42b) being stacked in a face-to-face manner, the second memory chip (42, 42a, 42b) and the third memory chip (43, 43a, 43b) being stacked in a back-to-back manner, and the third memory chip (43, 43a, 43b) and the fourth memory chip (44, 44a, 44b) being stacked in a face-to-face manner.

10. The chip stacked structure (40) according to claim 9, wherein
a first region (11) in the first memory chip (41, 41a, 41b), a second region (12) in the second memory chip (42, 42a, 42b), a third region (13) in the third memory chip (43, 43a, 43b), and a fourth region (14) in the fourth memory chip (44, 44a, 44b) are aligned with each other in the third direction;
a second region (12) in the first memory chip (41, 41a, 41b), a first region (11) in the second memory chip (42, 42a, 42b), a fourth region (14) in the third memory chip (43, 43a, 43b), and a third region (13) in the fourth memory chip (44, 44a, 44b) are aligned with each other in the third direction;
a third region (13) in the first memory chip (41, 41a, 41b), a fourth region (14) in the second memory chip (42, 42a, 42b), a first region (11) in the third memory chip (43, 43a, 43b), and a second region (12) in the fourth memory chip (44, 44a, 44b) are aligned with each other in the third direction; and
a fourth region (14) in the first memory chip (41, 41a, 41b), a third region (13) in the second memory chip (42, 42a, 42b), a second region (12) in the third memory chip (43, 43a, 43b), and a first region (11) in the fourth memory chip (44, 44a, 44b) are aligned with each other in the third direction.

11. The chip stacked structure (40) according to claim 10, wherein
n first vias (D0) in the first region (11) in the first memory chip (41, 41a, 41b), n second vias (D1) in the second region (12) in the second memory chip (42, 42a, 42b), n third vias (D2) in the third region (13) in the third memory chip (43, 43a, 43b), and n fourth vias (D3) in the fourth region (14) in the fourth memory chip (44, 44a, 44b) are aligned with each other in the third direction;
n second vias (D1) in the first region (11) in the first memory chip (41, 41a, 41b), n first vias (D0) in the second region (12) in the second memory chip (42, 42a, 42b), n fourth vias (D3) in the third region (13) in the third memory chip (43, 43a, 43b), and n third vias (D2) in the fourth region (14) in the fourth memory chip (44, 44a, 44b) are aligned with each other in the third direction;
n third vias (D2) in the first region (11) in the first memory chip (41, 41a, 41b), n fourth vias (D3) in the second region (12) in the second memory chip (42, 42a, 42b), n first vias (D0) in the third region (13) in the third memory chip (43, 43a, 43b), and n second vias (D1) in the fourth region (14) in the fourth memory chip (44, 44a, 44b) are aligned with each other in the third direction; and
n fourth vias (D3) in the first region (11) in the first memory chip (41, 41a, 41b), n third vias (D2) in the second region (12) in the second memory chip (42, 42a, 42b), n second vias (D1) in the third region (13) in the third memory chip (43, 43a, 43b), and n first vias (D0) in the fourth region (14) in the fourth memory chip (44, 44a, 44b) are aligned with each other in the third direction.

12. The chip stacked structure (40) according to claim 11, wherein
n first vias (D0) in the second region (12) in the first memory chip (41, 41a, 41b), n second vias (D1) in the first region (11) in the second memory chip (42, 42a, 42b), n third vias (D2) in the fourth region (14) in the third memory chip (43, 43a, 43b), and n fourth vias (D3) in the third region (13) in the fourth memory chip (44, 44a, 44b) are aligned with each other in the third direction;
n second vias (D1) in the second region (12) in the first memory chip (41, 41a, 41b), n first vias (D0) in the first region (11) in the second memory chip (42, 42a, 42b), n fourth vias (D3) in the fourth region (14) in the third memory chip (43, 43a, 43b), and n third vias (D2) in the third region (13) in the fourth memory chip (44, 44a, 44b) are aligned with each other in the third direction;
n third vias (D2) in the second region (12) in the first memory chip (41, 41a, 41b), n fourth vias (D3) in the first region (11) in the second memory chip (42, 42a, 42b), n first vias (D0) in the fourth region (14) in the third memory chip (43, 43a, 43b), and n second vias (D1) in the third region (13) in the fourth memory chip (44, 44a, 44b) are aligned with each other in the third direction; and
n fourth vias (D3) in the second region (12) in the first memory chip (41, 41a, 41b), n third vias (D2) in the first region (11) in the second memory chip (42, 42a, 42b), n second vias (D1) in the fourth region (14) in the third memory chip (43, 43a, 43b), and n first vias (D0) in the third region (13) in the fourth memory chip (44, 44a, 44b) are aligned with each other in the third direction.

13. The chip stacked structure (40) according to claim 12, wherein
n first vias (D0) in the third region (13) in the first memory chip (41, 41a, 41b), n second vias (D1) in the fourth region (14) in the second memory chip (42, 42a, 42b), n third vias (D2) in the first region (11) in the third memory chip (43, 43a, 43b), and n fourth vias (D3) in the second region (12) in the fourth memory chip (44, 44a, 44b) are aligned with each other in the third direction;
n second vias (D1) in the third region (13) in the first memory chip (41, 41a, 41b), n first vias (D0) in the fourth region (14) in the second memory chip (42, 42a, 42b), n fourth vias (D3) in the first region (11) in the third memory chip (43, 43a, 43b), and n third vias (D2) in the second region (12) in the fourth memory chip (44, 44a, 44b) are aligned with each other in the third direction;
n third vias (D2) in the third region (13) in the first memory chip (41, 41a, 41b), n fourth vias (D3) in the fourth region (14) in the second memory chip (42, 42a, 42b), n first vias (D0) in the first region (11) in the third memory chip (43, 43a, 43b), and n second vias (D1) in the second region (12) in the fourth memory chip (44, 44a, 44b) are aligned with each other in the third direction; and
n fourth vias (D3) in the third region (13) in the first memory chip (41, 41a, 41b), n third vias (D2) in the fourth region (14) in the second memory chip (42, 42a, 42b), n second vias (D1) in the first region (11) in the third memory chip (43, 43a, 43b), and n first vias (D0) in the second region (12) in the fourth memory chip (44, 44a, 44b) are aligned with each other in the third direction.

14. The chip stacked structure (40) according to claim 13, wherein
n first vias (D0) in the fourth region (14) in the first memory chip (41, 41a, 41b), n second vias (D1) in the third region (13) in the second memory chip (42, 42a, 42b), n third vias (D2) in the second region (12) in the third memory chip (43, 43a, 43b), and n fourth vias (D3) in the first region (11) in the fourth memory chip (44, 44a, 44b) are aligned with each other in the third direction;
n second vias (D1) in the fourth region (14) in the first memory chip (41, 41a, 41b), n first vias (D0) in the third region (13) in the second memory chip (42, 42a, 42b), n fourth vias (D3) in the second region (12) in the third memory chip (43, 43a, 43b), and n third vias (D2) in the first region (11) in the fourth memory chip (44, 44a, 44b) are aligned with each other in the third direction;
n third vias (D2) in the fourth region (14) in the first memory chip (41, 41a, 41b), n fourth vias (D3) in the third region (13) in the second memory chip (42, 42a, 42b), n first vias (D0) in the second region (12) in the third memory chip (43, 43a, 43b), and n second vias (D1) in the first region (11) in the fourth memory chip (44, 44a, 44b) are aligned with each other in the third direction; and
n fourth vias (D3) in the fourth region (14) in the first memory chip (41, 41a, 41b), n third vias (D2) in the third region (13) in the second memory chip (42, 42a, 42b), n second vias (D1) in the second region (12) in the third memory chip (43, 43a, 43b), and n first vias (D0) in the first region (11) in the fourth memory chip (44, 44a, 44b) are aligned with each other in the third direction.

15. The chip stacked structure (40) according to claim 9, wherein
a first region (11) in the first memory chip (41, 41a, 41b), a fourth region (14) in the second memory chip (42, 42a, 42b), a third region (13) in the third memory chip (43, 43a, 43b), and a second region (12) in the fourth memory chip (44, 44a, 44b) are aligned with each other in the third direction;
a second region (12) in the first memory chip (41, 41a, 41b), a third region (13) in the second memory chip (42, 42a, 42b), a fourth region (14) in the third memory chip (43, 43a, 43b), and a first region (11) in the fourth memory chip (44, 44a, 44b) are aligned with each other in the third direction;
a third region (13) in the first memory chip (41, 41a, 41b), a second region (12) in the second memory chip (42, 42a, 42b), a first region (11) in the third memory chip (43, 43a, 43b), and a fourth region (14) in the fourth memory chip (44, 44a, 44b) are aligned with each other in the third direction; and
a fourth region (14) in the first memory chip (41, 41a, 41b), a first region (11) in the second memory chip (42, 42a, 42b), a second region (12) in the third memory chip (43, 43a, 43b), and a third region (13) in the fourth memory chip (44, 44a, 44b) are aligned with each other in the third direction.

16. The chip stacked structure (40) according to claim 15, wherein
n first vias (D0) in the first region (11) in the first memory chip (41, 41a, 41b), n fourth vias (D3) in the fourth region (14) in the second memory chip (42, 42a, 42b), n third vias (D2) in the third region (13) in the third memory chip (43, 43a, 43b), and n second vias (D1) in the second region (12) in the fourth memory chip (44, 44a, 44b) are aligned with each other in the third direction;
n second vias (D1) in the first region (11) in the first memory chip (41, 41a, 41b), n third vias (D2) in the fourth region (14) in the second memory chip (42, 42a, 42b), n fourth vias (D3) in the third region (13) in the third memory chip (43, 43a, 43b), and n first vias (D0) in the second region (12) in the fourth memory chip (44, 44a, 44b) are aligned with each other in the third direction;
n third vias (D2) in the first region (11) in the first memory chip (41, 41a, 41b), n second vias (D1) in the fourth region (14) in the second memory chip (42, 42a, 42b), n first vias (D0) in the third region (13) in the third memory chip (43, 43a, 43b), and n fourth vias (D3) in the second region (12) in the fourth memory chip (44, 44a, 44b) are aligned with each other in the third direction; and
n fourth vias (D3) in the first region (11) in the first memory chip (41, 41a, 41b), n first vias (D0) in the fourth region (14) in the second memory chip (42, 42a, 42b), n second vias (D1) in the third region (13) in the third memory chip (43, 43a, 43b), and n third vias (D2) in the second region (12) in the fourth memory chip (44, 44a, 44b) are aligned with each other in the third direction.

17. The chip stacked structure (40) according to claim 16, wherein
n first vias (D0) in the second region (12) in the first memory chip (41, 41a, 41b), n fourth vias (D3) in the third region (13) in the second memory chip (42, 42a, 42b), n third vias (D2) in the fourth region (14) in the third memory chip (43, 43a, 43b), and n second vias (D1) in the first region (11) in the fourth memory chip (44, 44a, 44b) are aligned with each other in the third direction;
n second vias (D1) in the second region (12) in the first memory chip (41, 41a, 41b), n third vias (D2) in the third region (13) in the second memory chip (42, 42a, 42b), n fourth vias (D3) in the fourth region (14) in the third memory chip (43, 43a, 43b), and n first vias (D0) in the first region (11) in the fourth memory chip (44, 44a, 44b) are aligned with each other in the third direction;
n third vias (D2) in the second region (12) in the first memory chip (41, 41a, 41b), n second vias (D1) in the third region (13) in the second memory chip (42, 42a, 42b), n first vias (D0) in the fourth region (14) in the third memory chip (43, 43a, 43b), and n fourth vias (D3) in the first region (11) in the fourth memory chip (44, 44a, 44b) are aligned with each other in the third direction; and
n fourth vias (D3) in the second region (12) in the first memory chip (41, 41a, 41b), n first vias (D0) in the third region (13) in the second memory chip (42, 42a, 42b), n second vias (D1) in the fourth region (14) in the third memory chip (43, 43a, 43b), and n third vias (D2) in the first region (11) in the fourth memory chip (44, 44a, 44b) are aligned with each other in the third direction.

18. The chip stacked structure (40) according to claim 17, wherein
n first vias (D0) in the third region (13) in the first memory chip (41, 41a, 41b), n fourth vias (D3) in the second region (12) in the second memory chip (42, 42a, 42b), n third vias (D2) in the first region (11) in the third memory chip (43, 43a, 43b), and n second vias (D1) in the fourth region (14) in the fourth memory chip (44, 44a, 44b) are aligned with each other in the third direction;
n second vias (D1) in the third region (13) in the first memory chip (41, 41a, 41b), n third vias (D2) in the second region (12) in the second memory chip (42, 42a, 42b), n fourth vias (D3) in the first region (11) in the third memory chip (43, 43a, 43b), and n first vias (D0) in the fourth region (14) in the fourth memory chip (44, 44a, 44b) are aligned with each other in the third direction;
n third vias (D2) in the third region (13) in the first memory chip (41, 41a, 41b), n second vias (D1) in the second region (12) in the second memory chip (42, 42a, 42b), n first vias (D0) in the first region (11) in the third memory chip (43, 43a, 43b), and n fourth vias (D3) in the fourth region (14) in the fourth memory chip (44, 44a, 44b) are aligned with each other in the third direction; and
n fourth vias (D3) in the third region (13) in the first memory chip (41, 41a, 41b), n first vias (D0) in the second region (12) in the second memory chip (42, 42a, 42b), n second vias (D1) in the first region (11) in the third memory chip (43, 43a, 43b), and n third vias (D2) in the fourth region (14) in the fourth memory chip (44, 44a, 44b) are aligned with each other in the third direction.

19. The chip stacked structure (40) according to claim 18, wherein
n first vias (D0) in the fourth region (14) in the first memory chip (41, 41a, 41b), n fourth vias (D3) in the first region (11) in the second memory chip (42, 42a, 42b), n third vias (D2) in the second region (12) in the third memory chip (43, 43a, 43b), and n second vias (D1) in the third region (13) in the fourth memory chip (44, 44a, 44b) are aligned with each other in the third direction;
n second vias (D1) in the fourth region (14) in the first memory chip (41, 41a, 41b), n third vias (D2) in the first region (11) in the second memory chip (42, 42a, 42b), n fourth vias (D3) in the second region (12) in the third memory chip (43, 43a, 43b), and n first vias (D0) in the third region (13) in the fourth memory chip (44, 44a, 44b) are aligned with each other in the third direction;
n third vias (D2) in the fourth region (14) in the first memory chip (41, 41a, 41b), n second vias (D1) in the first region (11) in the second memory chip (42, 42a, 42b), n first vias (D0) in the second region (12) in the third memory chip (43, 43a, 43b), and n fourth vias (D3) in the third region (13) in the fourth memory chip (44, 44a, 44b) are aligned with each other in the third direction; and
n fourth vias (D3) in the fourth region (14) in the first memory chip (41, 41a, 41b), n first vias (D0) in the first region (11) in the second memory chip (42, 42a, 42b), n second vias (D1) in the second region (12) in the third memory chip (43, 43a, 43b), and n third vias (D2) in the third region (13) in the fourth memory chip (44, 44a, 44b) are aligned with each other in the third direction.

20. The chip stacked structure (40) according to any one of claims 9 to 19, wherein
in two memory chips connected face-to-face, vias aligned with each other in the third direction are connected through hybrid bonding structures; and in two memory chips connected back-to-back, vias aligned with each other in the third direction are connected through conductive bumps; or
in two memory chips connected face-to-face or two memory chips connected back-to-back, vias aligned with each other in the third direction are connected through hybrid bonding structures; or
in two memory chips connected face-to-face or two memory chips connected back-to-back, vias aligned with each other in the third direction are connected through conductive bumps.

21. The chip stacked structure (40) according to claim 20, wherein each of the memory chips further comprises 4n first drive circuits (30); and
in each of the memory chips, 4n first drive circuits (30) are connected to first terminals of 4n first vias (D0) in one-to-one correspondence, the first terminals being located on an active surface of the memory chip.

22. The chip stacked structure (40) according to claim 21, further comprising a logic chip (50), the first stacked unit being stacked on the logic chip (50) in the third direction, and each of the remaining stacked units being stacked on a previous stacked unit in the third direction,
the logic chip (50) comprising 16n fifth vias (502) and 16n second drive circuits (501), 4n fifth vias (502) being aligned with the 4n first vias (D0) in the first memory chip (41, 41a, 41b) in the third direction in one-to-one correspondence, 4n fifth vias (502) being aligned with the 4n second vias (D1) in the first memory chip (41, 41a, 41b) in the third direction in one-to-one correspondence, 4n fifth vias (502) being aligned with the 4n third vias (D2) in the first memory chip (41, 41a, 41b) in the third direction in one-to-one correspondence, and 4n fifth vias (502) being aligned with the 4n fourth vias (D3) in the first memory chip (41, 41a, 41b) in the third direction in one-to-one correspondence; and
the 16n second drive circuits (501) being connected to first terminals of the 16n fifth vias (502) in one-to-one correspondence, and the first terminals being located on an active surface of the logic chip (50).

23. The chip stacked structure (40) according to claim 22, further comprising 16n electrical paths,
one fifth via (502), m first vias (D0), m second vias (D1), m third vias (D2), and m fourth vias (D3) aligned with each other in the third direction being connected to form one electrical path if the chip stacked structure (40) comprises m stacked units, and m being a positive integer.

24. A memory, comprising the chip stacked structure (40) according to any one of claims 9 to 23.
